# EUROPÄISCHE PATENTSCHRIFT

(11) **EP 1 672 375 B1**
(45) Veröffentlichungstag und Bekanntmachung des Hinweises auf die Patenterteilung: **10.07.2013**
(21) Anmeldenummer: 05017934.0
(22) Anmeldetag: 18.08.2005
(51) Int. Cl.: G01R 22/06

(54) **Elektrizitätszähler**
Electricity meter
Compteur d'électricité

(30) Priorität: 18.12.2004 DE 202004019570 U
(43) Veröffentlichungstag der Anmeldung: 21.06.2006
(73) Patentinhaber: EMH metering GmbH & Co. KG, 19243 Wittenburg (DE)
(72) Erfinder: Malek, Norbert, 21438 Thieshope (DE)
(74) Vertreter: Hauck Patent- und Rechtsanwälte

(56) Entgegenhaltungen:
- EP-A- 0 447 615
- EP-A- 1 607 752
- EP-A2- 1 065 508
- WO-A-97/09623
- DE-U1-202004 000 858
- US-A- 5 523 559
- US-A1- 2002 186 000
- US-B1- 6 236 197
- "EHZ VDN-LASTENHEFT ELEKTRONISCHE HAUSHALTSZAEHLER", VDN - LASTENHEFT ELEKTRONISCHE HAUSHALTSZAEHLER, XX, XX, vol. V1.01, 20 June 2004 (2004-06-20), pages 1-41, XP007900451,

## Beschreibung

Die Erfindung bezieht sich auf einen Elektrizitätszähler nach dem Anspruch 1.

Es ist bekannt, Elektrizitätszähler in der Weise zu realisieren, daß eine Zählerplattform mit Anschlußmöglichkeiten für die Versorgungsleitungen an einem geeigneten Anbringungsort, z.B. dem Zählerschrank, angeordnet ist, und mit der Zählerplattform ein Gehäuse lösbar zu verbinden, das alle Bauteile und Komponenten eines elektronischen Elektrizitätszählers enthält, einschließlich eines Mikrorechners, der aus den Meßdaten des Zählers den Energieverbrauch errechnet und über ein Display zur Anzeige bringt. Zusätzlich oder alternativ werden die Meßdaten in einem lesbaren Speicher abgelegt und können über eine Schnittstelle des Elektrizitätszählers ausgelesen werden.

Das Gehäuse weist z.B. hakenartige Vorsprünge auf, die mit entsprechenden Ausnehmungen der Zählerplattform zusammenwirken. Dadurch findet eine Verhakung zwischen den Teilen statt, und ein Plombierelement, das sich durch das Gehäuse bis zur Plattform hin erstreckt, dient zur Verriegelung des Gehäuses an der Plattform. Das Plombierelement wird seinerseits am Gehäuse durch eine Plombe gesichert, so daß eine Abnahme des Gehäuses nur durch Entfernung oder Beschädigung der Plombe stattfinden kann.

Die beschriebene Anordnung hat den Vorteil, daß beim Lösen des Gehäuses von der Zählerplattform die Verbindung zum Versorger nicht unterbrochen ist und keine gefährlichen Arbeiten unter Spannung durchgeführt werden müssen. Ein Zähleraustausch läßt sich innerhalb kürzester Zeit bewerkstelligen, so daß fiir den Energieversorger Verluste nicht entstehen.

Das Zählergehäuse mit den aufgenommenen elektronischen Bauteilen und Komponenten wird naturgemäß herstellerseitig auf korrekte Verschaltung und funktionierende Betriebsweise getestet. Gleichwohl kann geschehen, daß später Fehler entstehen, welche den ordnungsgemäßen Betrieb des Elektrizitätszählers beeinträchtigen. Bei einer Erstmontage des Elektrizitätszählers und insbesondere der Zählerplattform, können durch Vertauschung der Anschlüsse oder unzureichende elektrische Verbindungen Fehler entstehen. Ferner muß sichergestellt sein, daß die Versorgungsleitungen die Größen bereitstellen, welche zur bestimmungsgemäßen elektrischen Energieversorgung vorgegeben sind. Die die Installation vornehmende Person kann mit Hilfe geeigneter separater Meßgeräte bei der Installation eine Überprüfung vornehmen.

Die Druckschrift DE 20 2004 000 858 U1 zeigt eine Stromzähleranordnung mit einem Stromzähler und einem Adapter sowie einer Plombiereinrichtung, mit der ein unbefugtes Entfernen des Stromzählers vom Adapter verhindert wird. Die Plombiereinrichtung weist eine Plombierstange auf, deren freies Ende einen Gewindeabschnitt aufweist, der in einen am Adapter angebrachten Innengewindeabschnitt einschraubbar ist.

Aus der Druckschrift EP 1 065 508 A2 ist ein Elektrizitätszähler mit einer Vorrichtung zum Erkennen eines Betrugsversuchs bekannt. Der bekannte Elektrizitätszähler kann ein Betrugsversuchssignal speichern, wenn er aus seiner Montageposition entfernt wird.

Aus der Druckschrift EP 0 447 615 A1 ist eine Einrichtung zur Überwachung von Apparategehäusen bekannt geworden. Die Stellung eines Plombier-elements wird mit einem Sensor erfasst und zur Erkennung eines Betragsversuches gespeichert. zur Erkennung eines Betrugsversuchs gespeichert.

Ein Elektrizitätszähler mit den Merkmalen des Oberbegriffs des Anspruchs 1 ist aus dem VDN-Lastenheft "Elektronische Haushaltszähler", Version 1.01, bekannt geworden.

Der Erfindung liegt die Aufgabe zugrunde, einen Elektrizitätszähler der eingangs genannten Art dahingehend auszubilden, daß vor der endgültigen Inbetriebnahme eine Überprüfung wichtiger Betriebsdaten auf automatischem Wege durchgeführt werden kann.

Diese Aufgabe wird durch die Merkmale des Anspruchs 1 gelöst.

Bei dem erfindungsgemäßen Elektrizitätszähler ist der Mikrorechner zwischen zwei Modi umschaltbar ausgebildet. Im Betriebsmodus, der für die gewünschte Funktion des Elektrizitätszählers maßgebend ist, wird in üblicher Weise die Verarbeitung und Anzeige und/oder Speicherung der Meßdaten vorgenommen, wozu nicht nur die gemessenen Ströme und Spannungen, Leistungen und Energiemengen zählen, sondern auch die Zeit sowie weitere, für den Energieversorger interessierenden Informationen. In dem Service- oder Prüfmodus ist der Mikrorechner in der Lage, zu Diagnosezwecken wichtige, für den Betrieb des Elektrizitätszählers und seines Anschlusses maßgebende Daten abzufragen. Hierzu gehören die korrekte Installation der Zählerplattform, der Betriebszustand der Versorgungsleitungen, der korrekte Anschluß der Versorgungsleitungen, die fehlerfreie Funktion von Komponenten und Bauteilen im Gehäuse des Zählers usw.. Mit dem Mikrorechner sind Mittel verbunden, die erfassen, ob das Plombierelement in der Verriegelungsposition ist und zwar derart, daß der Mikrorechner automatisch von dem Servicemodus in den Betriebsmodus umschaltet, wenn die Mittel die Verriegelungsposition anzeigen bzw. erfassen. Umgekehrt wird der Mikrorechner automatisch in den Servicemodus geschaltet, wenn das Plombierelement nicht in der Verriegelungsposition ist.

Im Servicemodus werden Daten gespeichert und/oder angezeigt, welche für die Überprüfung der Anlage, in der sich der elektronische Elektrizitätszähler befindet, hilfreich sind. Hierzu gehören unter anderem die Erfassung der einzelnen Phasenspannungen, das Drehfeld der Phasenspannungen, die Phasenströme, Phasenleistung und eine Information über die Energierichtung, die bekanntlich positiv sein muß. So kann eine Meldung über den korrekten Anschluß der Zählerplattform erhalten werden.

Als Plombierelement kann ein Plombierstift verwendet werden, der z.B. mit einem Gewinde im Gehäuse zusammenwirkt und bei einer Drehung axial vorbewegt wird. Zu Verriegelungszwecken kann ein solcher Plombierstift in eine Öffnung der Zählerplattform eingeführt werden, wodurch eine Relativverschiebung zwischen Gehäuse und Plattform blockiert ist. Dadurch kann das Gehäuse von der Zählerplattform nicht mehr abgenommen werden. Für die Ermittlung der Position des Plombierstifts kann ein Sensor verwendet werden, der eine Positionsbestimmung im Hinblick auf den Plombierstift vornimmt. Eine Sensierung kann z.B. mechanisch/elektrisch über einen Schalter erfolgen, mit Hilfe eines magnetisch wirkenden Sensors oder einer optischen Anordnung usw.. Die Positionssensierung reicht unter Umständen nicht aus, da die Aufhebung des Service- oder Prüfmodus erst erfolgen sollte, wenn das Zählergehäuse an der Zählerplattform wirklich verriegelt ist. Als weitere Bedingung kann daher die Spannungsmessung hinzutreten. Nur wenn die Verriegelungsposition des Plombierstifts ermittelt und gleichzeitig Betriebsspannung gemessen wird, ist dies ein Indiz dafür, daß der Zähler an die Zählerplattform angeschlossen ist. Erst dann findet eine Umschaltung in den Betriebsmodus statt und der Elektrizitätszähler kann seinen Betrieb beginnen.

Ein Ausführungsbeispiel der Erfindung wird nachfolgend anhand von Zeichnungen näher erläutert.
- Fig. 1: zeigt die Vorderansicht eines Elektrizitätszählers nach der Erfindung.
- Fig. 2: zeigt einen Schnitt durch die Darstellung nach Fig. 1 entlang der Linie 2-2.
- Fig. 3: zeigt schematisch ein Blockschaltbild zur Veranschaulichung der beiden Modi des Mikrorechners für den Elektrizitätszähler nach den Fign. 1 und 2.

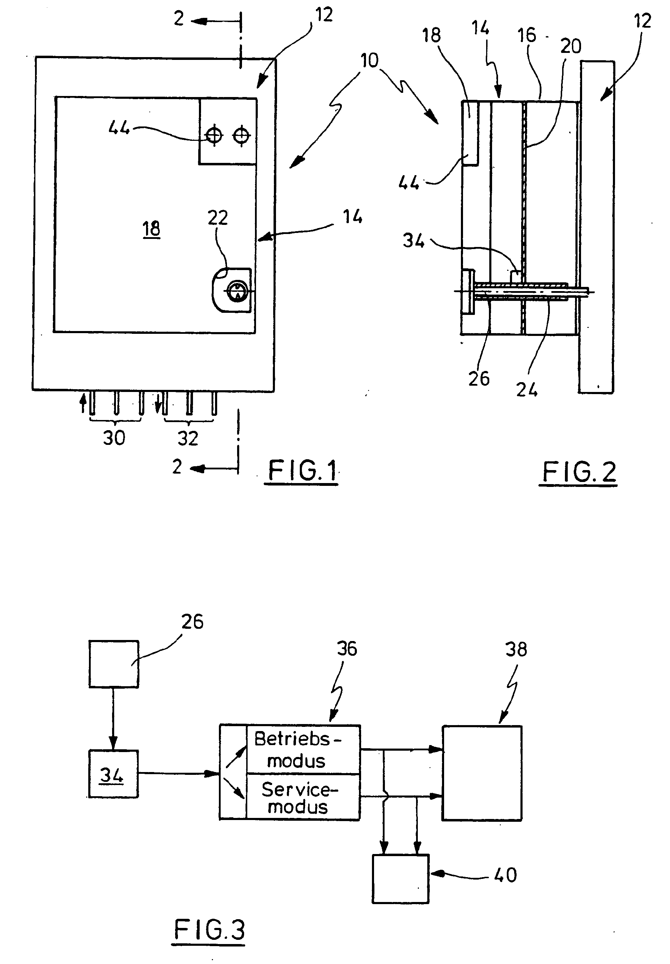

In den Fign. 1 und 2 ist ein elektronischer Elektrizitätszähler schematisch dargestellt. Er weist eine Zählerplattform 12 auf, die innerhalb eines Zählerschrankes an einer Wand angebracht ist. Alternativ kann die Zählerplattform auch die Wand eines Zählerschrankes bilden.

Auf die Zählerplattform 12 ist ein quaderförmiges Gehäuse 14 aufgesetzt, das aus einem kastenförmigen Unterteil 16, das mit der Zählerplattform 12 verbunden ist, und einem Deckel 18, der unlösbar mit dem Unterteil verbindbar ist, besteht. Die Verbindung zwischen Zählerplattform 12 und Unterteil 16 ist nicht dargestellt. Z.B. greifen hakenförmige Ansätze am Boden des Unterteils 16 in entsprechende Schlitze der Zählerplattform 12.

Im Gehäuse 14 sind alle für einen elektronischen Elektrizitätszähler notwendigen Bauteile und Komponenten untergebracht. Hierzu gehört auch ein Mikrorechner zur Verarbeitung der Meßdaten, die mit dem Zähler gemessen werden. Der Aufbau dieser Teile ist nicht dargestellt. Man erkennt lediglich eine Leiterplatte 20, welche die Komponenten und Bauteile sowie den Mikrorechner trägt und in geeigneter Weise am Unterteil 16 befestigt ist.

Wie aus Fig. 1 zu erkennen, weist der Deckel 18 einen eingesenkten Bereich 22 auf, an dem, wie in Fig. 2 zu erkennen, eine zylindrische Hülse 24 angeformt ist, die sich durch eine Öffnung der Leiterplatte 20 hindurch bis nahe an den Boden des Unterteils 16 erstreckt. Durch die Hülse 24 ist ein Plombierstift 26 hindurchgeführt, der durch eine Öffnung im Boden des Unterteils 16 hindurcherstreckt ist und in eine Verriegelungsöffnung (nicht gezeigt) der Zählerplattform 12 hineinsteht. Dadurch wird eine Verschiebung des Gehäuses 14 verhindert, die notwendig wäre, um das Gehäuse 14 zu entfernen. Der Plombierstift 26 kann mit einem Gewindeabschnitt versehen werden, welcher mit einem Gewindeabschnitt in der Öffnung im Boden des Unterteils 16 zusammenwirkt.

Der Plombierstift 26 steht geringfügig über eine Öffnung in der Einsenkung 22 des Deckels 18 vor. Die Einsenkung 22 dient als Tasche für die Plombe. Mit Hilfe des Plombierstifts 26 wird das Gehäuse 14 mithin an der Zählerplattform verriegelt und eine Entriegelung ist nur möglich, wenn die Plombe in der Einsenkung 22 entfernt oder zerstört wird.

In Fig. 1 ist bei 30 bzw. 32 der Anschluß des Netzes bzw. des Verbrauchers angedeutet. In der Zählerplattform 12 sind entsprechende Kontakte angeordnet, die mit Leiterabschnitten im Gehäuse 14 zusammenwirken, damit der zum Verbraucher fließende Strom und die Spannung gemessen werden können.

Auf der Leiterplatte 20 ist nahe der Öffnung für die Hülse 24 ein Positionssensor 34 angeordnet. Mit ihm kann z.B. festgestellt werden, ob der Plombierstift 26 in der Verriegelungsposition ist. Hierfür ist erforderlich, daß der Plombierstift 26 z. B. eine Markierung oder dergleichen für eine vorgegebene Lage bezüglich des Sensors 34 hat. Der Sensor kann ein optischer Sensor sein, ein magnetisch wirkender Sensor oder auch von einem elektromechanischen Schalter gebildet sein.

In Fig. 3 ist angezeigt, daß der Sensor 34 mit einem Mikrorechner 36, der ebenfalls auf der Leiterplatte 20 angeordnet ist, verbunden ist. Der Mikrorechner ist so ausgelegt, daß er wahlweise einen Betriebsmodus oder einen Servicemodus einnehmen kann. Der Sensor 34 erkennt, wenn der Plombierstift 26 in der Verriegelungsposition ist. In diesem Fall wird der Mikrorechner 36 in den Betriebsmodus umgeschaltet. Vorher war der Mikrorechner 36 im Servicemodus. Im Servicemodus ermittelt der Elektrizitätszähler sogenannte Diagnosedaten, welche für eine korrekte Installation der Zählerplattform 12, den Betriebszustand der Versorgungsleitungen 30 bzw. 32, die Installation der Komponenten und Bauteile auf der Leiterplatte 20 und so fort charakteristisch sind. Hierzu gehören mithin die Phasenspannungen und -ströme, die Phasenleistung, eine Information über die Energierichtung, der korrekte Anschluß der Versorgungsleitungen (Phasenfolge) und so fort. Diese Daten, die von den im Elektrizitätszähler vorhandenen Meßanordnungen ermittelt werden, werden in einem Speicher 38 abgelegt und/oder in einer Anzeige 40 angezeigt. Die Anzeige 40 kann das übliche Display sein, das normalerweise in einem Elektrizitätszähler vorhanden ist.

Wird das Gehäuse 14 in der beschriebenen Art und Weise auf die Zählerplattform 12 aufgesetzt und die elektrische Verbindung zum Elektrizitätszähler auf diese Weise hergestellt, befindet sich andererseits der Plombierstift 26 noch nicht in der Verriegelungsstellung. Dadurch kann der Mikrorechner 36 automatisch im Servicemodus eine Selbstdiagnose vornehmen. Wird am Abschluß der Installation der Plombierstift in die Verriegelungsstellung gebracht, kann dies vom Sensor 34 festgestellt werden, wodurch automatisch in den üblichen Betriebsmodus umgeschaltet wird.

Im Zähler kann eine Auswerteschaltung vorgesehen sein, welche die Meßdaten verarbeitet und ein Gut- oder Schlecht-Signal erzeugt, je nach Diagnose. Dieses Signal kann dann z.B. auf dem Display angezeigt werden. Die Anzeige kann fortbestehen, wenn inzwischen der Betriebsmodus eingenommen worden ist.

## Patentansprüche

1. Elektrizitätszähler mit einem Gehäuse (14) zur Aufnahme von Bauteilen und Komponenten des Elektrizitätszählers einschließlich eines Mikrorechners (36) zur Steuerung der Zählerfunktion, zum Errechnen des Energieverbrauchs aus Messdaten und zur Anzeige in einem Display (40) im Elektrizitätszähler und/oder Speicherung von Messdaten in einem lesbaren Speicher (38), wobei der Elektrizitätszähler zur Verwendung mit einer Zählerplattform (12), die Anschlüsse (30, 32) für die einzelnen Phasen der elektrischen Versorgungsleitungen sowie Kontakte aufweist, die mit Kontakten des Elektrizitätszählers im Gehäuse (14) zusammenwirken, wenn das Gehäuse (14) auf die Zählerplattform (12) aufgesteckt ist, wobei der Mikrorechner (36) einen Betriebsmodus, in dem zur Durchführung der Zählerfunktion Messdaten angezeigt und/oder gespeichert werden, aufweist, wobei zwischen Gehäuse (14) und Zählerplattform (12) ein Plombierelement (26) zwischen einer Entriegelungsposition und einer Verriegelungsposition verstellbar ist und in der Verriegelungsposition das Gehäuse (14) an der Zählerplattform (12) verriegelt, wobei das Plombierelement (26) durch eine Plombe am Gehäuse (14) sicherbar ist, so dass das Gehäuse (14) nur unter Entfernung oder Beschädigung der Plombe abnehmbar ist, **dadurch gekennzeichnet, dass**
• der Mikrorechner (36) einen Servicemodus aufweist, in dem Diagnosedaten, die für den Korrekten Anschluss der Versorgungsleitungen (30, 32) und/oder den Betriebszustand der Versorgungsleitungen (30, 32) kennzeichnend sind, gemessen und im Display (40) angezeigt und/oder im Speicher (38) gespeichert werden,
• der Mikrorechner (36) vom Betriebsmodus in den Servicemodus umschaltbar ausgebildet ist, wobei
• mit dem Mikrorechner (36) Mittel (34) verbunden sind zur Erfassung, ob das Plombierelement (26) in der Verriegelungsposition ist, derart, dass der Mikrorechner (36) automatisch von dem Servicemodus in den Betriebsmodus umgeschaltet wird, wenn die Mittel (34) die Verriegelungsposition des Plombierelements (26) erfassen, und automatisch von dem Betriebsmodus in den Servicemodus umgeschaltet wird, wenn das Plombierelement (26) nicht in der Verriegelungsposition ist.

2. Elektrizitätszähler nach Anspruch 1, **dadurch gekennzeichnet, dass** der Mikrorechner (36) dazu eingerichtet ist, im Servicemodus die einzelnen Phasenspannungen und/oder -ströme, die Richtung des sich aus den Phasenspannungen ergebenden Drehfelds und/oder die Phasenleistungen und/oder die Energierichtung zu messen, anzuzeigen und/oder zu speichern.

3. Elektrizitätszähler nach Anspruch 1 oder 2, **dadurch gekennzeichnet, dass** das Gehäuse (14) des Zählers eine Datenschnittstelle (44) aufweist zum Auslesen der in Betriebs- und Servicemodus ermittelten Daten.

4. Elektrizitätszähler nach einem der Ansprüche 1 bis 3, **dadurch gekennzeichnet, dass** ein Sensor zur Detektierung der Position des Plombierelements (26) vorgesehen ist.

5. Elektrizitätszähler nach Anspruch 4, **dadurch gekennzeichnet, dass** ein optischer, elektromechanischer oder magnetisch wirkender Sensor vorgesehen ist.

6. Elektrizitätszähler nach Anspruch 4, **dadurch gekennzeichnet, dass** ein Drucksensor vorgesehen ist.

7. Elektrizitätszähler nach einem der Ansprüche 1 bis 6, **dadurch gekennzeichnet, dass** eine interne Auswerteschaltung zur Auswertung der im Servicemodus ermittelten Daten vorgesehen ist, die zur Ausgabe oder Anzeige einer Gut-/Schlecht-Meldung ausgebildet ist.

8. Elektrizitätszähler nach Anspruch 7, **dadurch gekennzeichnet, dass** die Auswerteschaltung so ausgebildet ist, dass die Gut-/Schlecht-Meldung auch im Betriebsmodus angezeigt wird.

## Claims

1. An electricity meter with a case (14) for housing assembly parts and components of the electricity meter, including a microcomputer (36) for controlling the meter function, for calculating the energy consumption from measurement data and for indicating on a display (40) in the electricity meter and/or for memorising measurement data in a readable memory (38), wherein the electricity meter is configured for utilisation with a meter platform (12) which comprises terminals (30, 32) for the individual phases of the electric supply lines as well as contacts which co-operate with contacts of the electricity meter in the case (14) when the case (14) is plugged onto the meter platform (12), wherein the microcomputer (36) comprises an operation mode in which measurement data are indicated and/or memorised for performing the meter function, wherein a lead sealing element (26) between case (14) and meter platform (12) is adjustable between an unlocking position and a locking position and locks the case (14) on the meter platform (12) in the locking position, the lead sealing element (26) being securable on the case (14) by a lead seal so that the case can be detached only under removal or damage of the lead seal; **characterised in that**
• the microcomputer (36) has a service mode, wherein diagnostic data that are characteristic for the correct connection of the supply lines (30, 32) and/or for the operational condition of the supply lines (30, 32) are measured or indicated in the display (40) and/or memorised in the memory (38),
• the microcomputer is configured so as to be switchable from the operation mode to the service mode, wherein
• means (34) are connected to the microcomputer (36) for detecting whether the lead sealing element (26) is in the locking position, such that the microcomputer (36) is automatically switched over from the service mode into the operation mode when the means (34) detect the locking position of the lead sealing element (26), and is automatically switched over from the operation mode into the service mode when the lead sealing element (26) is not in the locking position.

2. The electricity meter according to claim 1, **characterised in that** the microcomputer (36) is configured to measure, to indicate and/or to memorize the individual phase voltages and/or -currents, the direction of the revolving field resulting from the phase voltages and/or the phase wattages and/or the energy direction when it is in the service mode.

3. An electricity meter according to claim 1 or 2, **characterised in that** the case (14) of the meter has a data interface (44) for reading out the data determined in the operation- and service mode.

4. An electricity meter according to any one of claims 1 to 3, **characterised in that** a sensor is provided for detecting the position of the lead sealing element (26).

5. The electricity meter according to claim 4, **characterised in that** an optical, electromechanical or magnetically acting sensor is provided.

6. The electricity meter according to claim 4, **characterised in that** a pressure sensor is provided.

7. An electricity meter according to any one of claims 1 to 6, **characterised in that** an internal analysing circuitry for analysing the data determined in the service mode is provided, which is configured for the output or display of a good-/bad message.

8. The electricity meter according to claim 7, **characterised in that** the analysing circuitry is configured such that the good-/bad message is displayed also in the operation mode.

## Revendications

1. Compteur d'électricité avec un boîtier (14) pour le logement d'éléments de construction et de composants du compteur d'électricité, y compris un micro processeur (36) pour contrôler la fonction du compteur, pour calculer la consommation d'énergie à partir de données de mesure et pour indication dans un panneau d'affichage (40) dans le compteur d'électricité et/ou pour l'enregistrement de données de mesure dans une mémoire lisible (38), dans lequel le compteur d'électricité est configuré pour l'utilisation avec une plate-forme de compteur (12) qui comporte des bornes (30, 32) pour les phases individuelles des lignes d'alimentation aussi bien que des contacts qui coopèrent avec des contacts du compteur d'électricité dans le boîtier (14) quand le boîtier (14) est fiché sur la plate-forme de compteur (12), le micro processeur (36) comportant un mode de fonctionnement dans lequel des données de mesure sont affichées et/ou mé morisées pour effectuer la fonction du compteur, un élément de plombage (26) entre le boîtier (14) et la plate-forme de compteur (12) étant ajustable entre une position de déverrouillage et une position de verrouillage et verrouille le boîtier (14) sur la plate-forme de compteur (12) dans la position de verrouillage, l'élément de plombage (26) étant sécurisable sur le boîtier (14) par un plomb, de sorte que le boîtier peut être détaché seulement en enlevant ou endommageant la plombe, **caractérisé en ce que**
• le micro processeur (36) a un mode de service, dans lequel des données diagnostiques qui sont caractéristiques pour la connexion correcte des lignes d'alimentation (30, 32) et/ou pour la condition de fonctionnement des lignes d'alimentation (30, 32) sont mesurées et indiquées dans le panneau d'affichage (40) et/ou mémorisées dans la mémoire (38),
• le micro processeur est configuré pour changer du mode de fonctionnement au mode de service, dans lequel
• des moyens (34) sont reliés au micro processeur (36) pour détecter si l'élément de plombage (26) est dans la position de verrouillage, de sorte que le micro processeur (36) est automatiquement changé du mode de service au mode de fonctionnement quand les mo yens (3 4) détectent la position de verrouillage de l'élément de plombage (26), et est automatiquement changé du mode de fonctionnement au mode de service quand l'élément de plombage (26) n'est pas dans la position de verrouillage.

2. Compteur d'électricité selon la revendication 1, **caractérisé en ce que** le micro processeur (36) est configuré à mesurer, indiquer et/ou mémoriser les tensions et/ou courants de phase individuelles, la direction du champ rotatif qui résulte des tensions de phase et/ou les puissances de phase et/ou la direction de l'énergie quand il est dans le mode de service.

3. Compteur d'électricité selon la revendication 1 or 2, **caractérisé en ce que** le boîtier (14) du compteur comporte une interface de données (44) pour lire des données déterminées dans les modes de fonctionnement et de service.

4. Compteur d'électricité selon l'une quelconque des revendications 1 à 3, **caractérisé en ce que** un capteur est pourvu pour détecter la position de l'élément de plombage (26).

5. Compteur d'électricité selon la revendication 4, **caractérisé en ce que** un capteur est pourvu qui est optique, électromécanique ou fonctionnant de manière magnétique.

6. Compteur d'électricité selon la revendication 4, **caractérisé en ce que** un capteur de pression est pourvu.

7. Compteur d'électricité selon l'une quelconque des revendications 1 à 6, **caractérisé en ce que** un circuit d'analyse est pourvu pour analyser les données déterminées dans le mode de service et qui est configuré pour faire sortir ou indiquer un message bon/mal.

8. Compteur d'électricité selon la revendication 7, **caractérisé en ce que** le circuit d'analyse est configuré de sorte que le message bon/mal est affiché aussi dans le mode de fonctionnement.
